Europäisches Patentamt

European Patent Office

Office européen des brevets

(19)

(11) EP 0 809 883 B1

(12) **EUROPÄISCHE PATENTSCHRIFT**

(45) Veröffentlichungstag und Bekanntmachung des Hinweises auf die Patenterteilung:
**29.12.1999 Patentblatt 1999/52**

(21) Anmeldenummer: **96900533.9**

(22) Anmeldetag: **20.01.1996**

(51) Int Cl.$^6$: **H03H 21/00**

(86) Internationale Anmeldenummer:
**PCT/DE96/00080**

(87) Internationale Veröffentlichungsnummer:
**WO 96/26573 (29.08.1996 Gazette 1996/39)**

(54) **VORRICHTUNG ZUR ENTZERRUNG EINER FEHLERSTRECKE IN EINEM ÜBERTRAGUNGSSYSTEM**

DISTORTION CORRECTION DEVICE FOR A PATH OF PROPAGATION IN TRANSMISSION SYSTEMS

DISPOSITIF DE CORRECTION DES DISTORSIONS DANS UNE SECTION DE PROPAGATION D'UN SYSTEME DE TRANSMISSION

(84) Benannte Vertragsstaaten:
**CH DE ES FR GB IT LI SE**

(30) Priorität: **18.02.1995 DE 19505611**

(43) Veröffentlichungstag der Anmeldung:
**03.12.1997 Patentblatt 1997/49**

(73) Patentinhaber: **ROBERT BOSCH GMBH 70442 Stuttgart (DE)**

(72) Erfinder:
• **BENDEL, Karl
D-71701 Schwieberdingen (DE)**
• **AREVALO, Luis
D-70193 Stuttgart (DE)**
• **HILLER, Christoph
D-73728 Esslingen (DE)**

(56) Entgegenhaltungen:
**US-A- 5 243 686**

• **1994 IEEE MTT-S INTERN. SYMP. DIGEST. SAN DIEGO (US), 23-25 MAY 94; P701-704, VOL2. ESWARAPPA et al: AUTOREGRESSIVE (AR) SPEC- TRAL ESTIMATION TECHNIQUE FOR FASTER... XP000516647**

EP 0 809 883 B1

**Beschreibung**

Stand der Technik

Die Erfindung geht aus von einer Vorrichtung zur Entzerrung einer Fehlerstrecke in einem Übertragungssystem, insbesondere einem elektrisch-akustisch gemischten Übertragungssystem, wie es besonders vorteilhaft Verwendung finden kann bei einem System zur aktiven Geräuschminderung, der im Oberbegriff des Anspruchs 1 definierten Gattung.

Bei Übertragungssystemen, insbesondere bei solchen, die sowohl aus elektrischen als auch aus akustischen Bauelementen bestehen, gibt es mit Verzerrungen behaftete Strecken, bei denen über die Strecke geschickte Signale wegen des frequenzselektiven Verhaltens der Strecke unterschiedlich gedämpft werden. Dies bedeutet, daß verschiedene Frequenzkomponenten des Signals mit sehr unterschiedlicher Amplitude am Empfangsort ankommen, auch wenn sie am Eingang der Strecke die gleiche Amplitude aufwiesen. Insbesondere dann ist dies von erheblichem Nachteil, wenn das Signal über adaptive Filter geschickt werden soll, weil die Frequenzselektivität der Strecke hier dafür sorgt, daß das Filter nur eine sehr langsame Konvergenz aufweist, weil erst sehr spät stark gedämpfte Frequenzanteile des Signals berücksichtigt werden. Dies beinhaltet andererseits auch den Nachteil, daß das Filter sehr träge oder überhaupt nicht auf schnelle Änderungen der spektralen Zusammensetzung des Signals reagiert.

In dem Dokument: 1994 IEEE MTT-S Intern. Symp. Digest, San Diego (US), 23-25 May 1994, p. 701 - 704. vol. 2, C. Eswarappa et al.: "Autoregressive (AR) Spectral Estimation Technique for Faster TLM Analysis of Microwave Structures", ist eine spektrale Abschätzungstechnik beschrieben, die auf der autoregressiven Methode basiert und zur Verbesserung der Effektivität der Methode der Übertragungsleitungsmethode (TLM-Methode) dient. Diese Technik kann benutzt werden, um die Antwort in der vollen Zeitdomäne zu berechnen aufgrund eines relativ kurzen Segments der frühen TLM-Antwort. Die Anwendung der Methode auf einen Bandpaßfilter, der aus einem Wellenleiter mit drei Abschnitten aufgebaut ist, zeigt bei einer Frequenz von 35 GHz, daß diese Technik sehr genaue Streuungs-Parameter ergibt bei einer Einsparung des Berechnungsaufwands um den Faktor 5.

US-A-5 243 686 beschreibt eine Methode zur Parameterbestimmung akustischer Signale, die auf einem mehrstufigen linearen Prädiktor basiert. Dabei werden Informationen erster und zweiter Ordnung ermittelt und miteinander kombiniert, um beispielsweise akustische Signalquellen zu analysieren und über einen Vergleich mit einem bekannten Muster zu identifizieren. Dies kann z. B. zur Identifizierung verschiedener Fahrzeuge über die Analyse der Motorengeräusche dienen.

Keines dieser beiden Dokumente beinhaltet eine Fehlerstrecke in einem Übertragungssystem, einen Entzerrer dazu, und auch keinen Transversalfilter als Entzerrer. Darüber hinaus enthalten beide Dokumente weder Hinweise darauf, einen Entzerrer als Transversalfilter aufzubauen, noch darauf, das Transversalfilter auf der Basis der linearen Prädiktion zu entwerfen.

Vorteile der Erfindung

Die Erfindung ist in den unabhängigen Ansprüchen angegeben.

Die erfindungsgemäße Vorrichtung zur Entzerrung einer Fehlerstrecke in einem Übertragungssystem mit den kennzeichnenden Merkmalen des Anspruchs 1 hat demgegenüber den Vorteil der vollständigen Betragsentzerrung der Fehlerstrecke ohne Hinzufügen zusätzlicher großer Verzögerungen. Hierzu wird ein minimalphasiges System verwendet. Durch diese Betragsentzerrung kommt kein Frequenzanteil des Signals wesentlich stärker gedämpft am Ziel an als andere.

Der grundlegende Gedanke bei der vorliegenden Erfindung besteht darin, daß der Entzerrer aus einem Transversalfilter aufgebaut ist, und daß der Entwurf für dieses Transversalfilter auf der Basis der linearen Prädiktion beruht.

Die Anwendung eines linearen Prädiktors ist bislang nur bekannt im Zusammenhang mit der Anwendung auf Signale, insbesondere Sprachsignale. Eine Anwendung dagegen auf lineare, frequenzselektive Übertragungssysteme ist neu und beinhaltet den überraschenden Effekt, frequenzselektive Strecken in einem Übertragungssystem effektiv auf einfache Weise zu entzerren, ohne die Streckenverzögerung drastisch zu erhöhen, wie dies bei der sogenannten "Inversen Modellierung" der Fall ist.

Durch die in den weiteren Ansprüchen aufgeführten Maßnahmen sind vorteilhafte Weiterbildungen und Verwendungen der im Anspruch 1 angegebenen Vorrichtung möglich.

Gemäß einer vorteilhaften Weiterbildung der grundsätzlichen Idee der Erfindung wird aus einer bestimmten Anzahl NE von Koeffizienten der identifizierten Strecken-Impulsantwort $h_{Err}(k)$ der Fehlerstrecke die zugehörige Autokorrelierte $\rho(\kappa)$ nach folgender Bestimmungsgleichung ermittelt:

$$\rho(\kappa) = \sum_{\kappa=0}^{NE-1-\kappa} = h_{Err}(k) \cdot h_{Err}(k+\kappa) \quad .$$

In weiterer vorteilhafter Ausgestaltung der Erfindung werden mit Hilfe der Durbin-Levinson-Rekursion die Yule-Walker- Gleichungen für die Koeffizienten $a_1 \ldots a_N$ des linearen Prädiktors vorgebbarer Ordnung (N) gelöst. Diese Gleichungen lauten:

$$\begin{bmatrix} \rho(0) & \rho(1) & \ldots & \rho(N-1) \\ \rho(1) & \rho(0) & \ldots & \rho(N-2) \\ \ldots & \ldots & \ldots & \ldots \\ \rho(N-1) & \ldots & \ldots & \rho(0) \end{bmatrix} \begin{bmatrix} a_1 \\ \ldots \\ a_N \end{bmatrix} = \begin{bmatrix} \rho(1) \\ \ldots \\ \rho(N) \end{bmatrix} \quad .$$

Für die Koeffizienten der Entzerrerimpulsantwort resultiert schließlich daraus die Folge {$1$, $-a_1$, $-a_2$, ... ,$-a_N$}. Um Dämpfungsfreiheit zu erreichen, sind diese Koeffizienten mit der Wurzel der aus der Durbin-Levinson-Rekursion ebenfalls hervorgehenden Prädiktionsfehlerleistung bei der Ordnung N zu normieren.

Eine besondere Konsequenz vorliegender Erfindung ist die Verwendung eines linearen Prädiktors bei einem System, wobei das System aus einem Übertragungsblock besteht, der insbesondere in Form eines digitalen Filters beschrieben ist.

Weiterhin besonders vorteilhaft ist die Verwendung des linearen Prädiktors als Entzerrungsvorrichtung in einem Übertragungssystem, insbesondere in einem Übertragungssystem, welches sowohl aus elektrischen, als auch aus akustischen Bauelementen besteht.

Die Erfindung ist anhand der nachfolgenden Beschreibung näher erläutert und ihre Verwendung anhand eines in der Zeichnung dargestellten Ausführungsbeispiels näher erläutert.

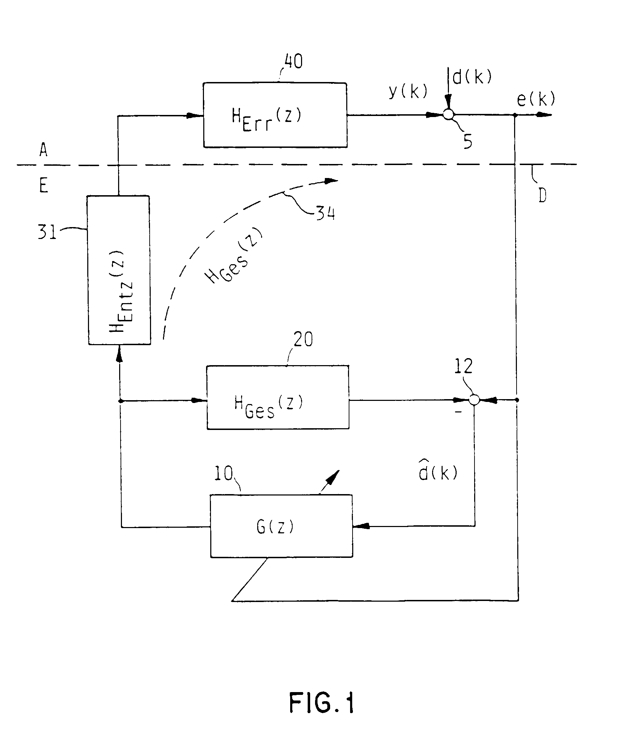

Die einzige Figur, Fig. 1, zeigt ein Strukturbild in regelungstechnischer Darstellung, mit der eine Anwendung des erfindungsgemäßen linearen Prädiktors bei einem System zur aktiven Geräuschdämpfung erläutert wird.

Beschreibung des Ausführungsbeispiels

Gemäß einer bevorzugten Ausführung der Erfindung ist der Entzerrer als Transversalfilter realisiert. Der Entwurf dieses Filters basiert auf dem Prinzip der linearen Prädiktion. Dabei wird aus einer bestimmten Anzahl NE, z.B. 100, von Koeffizienten einer identifizierten Strecken-Impulsantwort $h_{err}(k)$ die zugehörige Autokorrelierte $\rho(\kappa)$ bestimmt. Die Bestimmungsgleichung dafür lautet wie folgt:

$$\rho(\kappa) = \sum_{\kappa=0}^{NE-1-\kappa} = h_{Err}(k) \cdot h_{Err}(k+\kappa) \quad .$$

Mit Hilfe der Durbin-Levinson-Rekursion werden damit die Yule-Walker-Gleichungen für die Koeffizienten

$a_1 \ldots a_N$ des linearen Prädiktors vorgebbarer Ordnung *(N)*, also folgendes Gleichungssystem gelöst:

$$\begin{bmatrix} \rho(0) & \rho(1) & \ldots & \rho(N-1) \\ \rho(1) & \rho(0) & \ldots & \rho(N-2) \\ \ldots & \ldots & \ldots & \ldots \\ \rho(N-1) & \ldots & \ldots & \rho(0) \end{bmatrix} \begin{bmatrix} a_1 \\ \ldots \\ a_N \end{bmatrix} = \begin{bmatrix} \rho(1) \\ \ldots \\ \rho(N) \end{bmatrix}$$

Für die Koeffizienten der Entzerrerimpulsantwort resultiert daraus schließlich die Folge {*1*, *-$a_1$*, *-$a_2$*, ... , *-$a_N$*}. Um Dämpfungsfreiheit zu erreichen, sind diese Koeffizienten mit der Wurzel der aus der Durbin-Levinson-Rekursion ebenfalls hervorgehenden PrädiKtionsfehlerleistung bei der Ordnung N zu normieren.

Der lineare Prädiktor, wie er vorstehend beschrieben ist, wird auf ein System ver- bzw. angewendet. Dieses System besteht vorzugsweise aus einem Übertragungsblock. Der Übertragungsblock seinerseits wird bevorzugt durch ein FIR-Filter beschrieben. Ein FIR-Filter (Finite Impulse Response Filter), ist ein Filter mit begrenztem Ansprechen auf einen Impuls.

Das FIR-Filter bildet eine Entzerrungsvorrichtung in einer Fehlerstrecke eines Übertragungssystem, insbesondere eines solchen, welches sowohl aus elektrischen, als auch aus akustischen Bauteilen besteht.

In der Figur 1 ist an einem Strukturbild in regelungstechnischer Darstellung die Anwendung des erfindungsgemäßen linearen Prädiktors bei einer Anordnung zur aktiven Geräuschdämpfung, die in Form einer Regelungs- bzw. Feedback-Struktur aufgebaut ist, dargestellt. Bei der Feedback-Stuktur eines derartigen Systems zur aktiven Geräuschdämpfung fallen Referenz- und Fehlersensor zusammen, d.h. das einzige verwendete Mikrophonsignal dient sowohl zur Ansteuerung eines adaptiven Reglers 10, als auch zur Kontrolle der Adaption dieses Reglers 10. In das System ist ein Entzerrer eingefügt. Auf der akustischen Seite A ist ein Block 40 gezeigt, der eine Fehlerstrecke mit der Übertragungsfunktion $H_{Err}(z)$ darstellt. Am Ausgang dieser Fehlerstrecke steht ein Kompensationssignal y(k) an, welches mit einem Störgeräusch d(k) überlagert wird. Am Punkt 5, dem Ort des einzigen, nicht näher dargestellten Mikrophons, wird das Ergebnis dieser Überlagerung als Fehlersignal e(k) ermittelt. Dieses Fehlersignal e(k) wird auf der elektrischen Seite E, die von der akustischen Seite A durch die gestrichelte Linie D symbolisch getrennt dargestellt ist, dem Punkt 12 und dem Adaptionseingang des Blocks 10, der den adaptiven Regler 10 mit der Funktion G(z) repräsentiert, zugeführt. Der Ausgang des Reglers 10 ist auf den Eingang eines Blocks 31 geführt, welcher den Entzerrer mit der entzerrten Übertragungsfunktion $H_{Entz}(z)$ darstellt. Weiterhin ist der Ausgang des Reglers 10 auf den Eingang eines Blocks 20 geführt, der das Streckenmodell der gesamten Fehlerstrecke mit der Übertragungsfunktion $H_{Ges}(z)$ repräsentiert.

Die gesamte Fehlerstrecke auf der elektrischen Seite E, d.h. Block 31, und auf der akustischen Seite A, d.h. Block 40, ist durch den gebogenen, gestrichelt dargestellten Pfeil 34 angedeutet. Sie ist auch mit der Übertragungsfunktion $H_{Ges}(z)$ zu bezeichnen. Ein Streckenmodell 20, das antiparallel zum Regler 10 geschaltet ist, weist dieselbe Übertragungsfunktion auf. Diesem Streckenmodell 20 wird an seinem Eingang der Ausgang des Reglers 10 zugeführt. Der Ausgang des Streckenmodells 20 wird mit negativem Vorzeichen auf den Summationspunkt 12 gegeben. Dadurch wird ein Signal d(k) erzeugt, welches als bereinigtes Störgeräusch zu bezeichnen ist, in welchem sich der "möglichst reine" Störschall wiederfindet und dem Regler 10 zur Erzeugung eines adäquaten Kompensationssignals y(k) zugeführt wird. Auf diese Weise wird mit dieser so gestalteten Feedback-Struktur durch die ermöglichte möglichst genaue Ermittlung des Störgeräuschs d(k), eine äquivalente Steuerungs- bzw. Controller-Feedforward Anordnung.

Der lineare Prädiktor gemäß vorliegender Erfindung findet mit großer Effektivität Verwendung in digitalen Systemen, um dort die mit linearen Verzerrungen behaftete Strecke betragsmäßig zu entzerren. Somit erscheinen die einzelnen Signalanteile unterschiedlicher Frequenzen nicht verschieden stark gedämpft, sondern im wesentlichen mit der ursprünglichen Amplitude. Dadurch ist das so erhaltene Signal besonders gut in angeschlossenen adaptiven Reglern zu verwenden, um dort durch die geringen Verzögerungen das möglichst schnelle Ansprechen auf Änderungen der spektralen Zusammensetzung der zu regelnden Größe zu ermöglichen.

**Patentansprüche**

1.   Vorrichtung zur Entzerrung einer Fehlerstrecke in einem Übertragungssystem, insbesondere einem elektrisch-akustisch gemischten Übertragungssystem, wie es besonders vorteilhaft Verwendung finden kann bei einem System zur aktiven Geräuschminderung,

dadurch gekennzeichnet, daß
der Entzerrer aus einem Transversalfilter aufgebaut ist, und daß der Entwurf für dieses Transversalfilter auf der Basis der linearen Prädiktion beruht.

2. Vorrichtung nach Anspruch 1, dadurch gekennzeichnet, daß aus einer bestimmten Anzahl NE von Koeffizienten der identifizierten Strecken-Impulsantwort $h_{Err}(k)$ der Fehlerstrecke die zugehörige Autokorrelierte $\rho(\kappa)$ nach folgender Bestimmungsgleichung ermittelt wird:

$$\rho(\kappa) = \sum_{\kappa=0}^{NE-1-\kappa} = h_{Err}(k) \cdot h_{Err}(k + \kappa)$$

3. Vorrichtung nach Anspruch 1 oder 2, dadurch gekennzeichnet, daß mit Hilfe der Durbin-Levinson-Rekursion die Yule-Walker-Gleichungen für die Koeffizienten $a_1 \ldots a_N$ des linearen Prädiktors vorgebbarer Ordnung $(N)$ gelöst werden, wobei die Gleichungen lauten:

$$\begin{bmatrix} \rho(0) & \rho(1) & \ldots & \rho(N-1) \\ \rho(1) & \rho(0) & \ldots & \rho(N-2) \\ \ldots & \ldots & \ldots & \ldots \\ \rho(N-1) & \ldots & \ldots & \rho(0) \end{bmatrix} \begin{bmatrix} a_1 \\ \ldots \\ a_N \end{bmatrix} = \begin{bmatrix} \rho(1) \\ \ldots \\ \rho(N) \end{bmatrix} ,$$

und wobei für die Koeffizienten der Entzerrerimpulsantwort schließlich die Folge {$1, -a_1, -a_2, \ldots , -a_N$} daraus resultiert.

4. Verwendung eines linearen Prädiktors für den Entwurf eines Transversalfilters, insbesondere in der Ausgestaltung gemäß einem der vorigen Ansprüche, bei einem System, wobei das System aus einem linearen, frequenzselektivem Übertragungsblock besteht, der insbesondere in Form eines digitalen Filters beschreibbar ist.

5. Verwendung eines linearen Prädiktors gemäß Anspruch 4 als Entzerrungsvorrichtung in einem Übertragungssystem, insbesondere in einem Übertragungssystem, welches sowohl aus elektrischen, als auch aus akustischen Bauelementen besteht.

6. Verwendung eines linearen Prädiktors gemäß Anspruch 3 oder 4, dadurch gekennzeichnet, daß das Filter des Übertragungsblocks ein FIR-Filter ist, d.h. als Finite Impulse Response Filter ein Filter mit begrenztem Ansprechen auf einen Impuls ist.

## Claims

1. Device for correcting a faulty link in a transmission system, in particular an electrically and acoustically mixed transmission system, such as can be used particularly advantageously in a system for active noise reduction, characterized in that the corrector is constructed from a transversal filter, and in that the design for this transversal filter is based on linear prediction.

2. Device according to Claim 1, characterized in that the associated autocorrelate $\rho(\kappa)$ is determined from a specific number NE of coefficients of the identified link-pulse response $h_{Err}(k)$ of the faulty link in accordance with the following conditional equation:

$$\rho(\kappa) = \sum_{\kappa = 0}^{NE - 1 - \kappa} = h_{Err}(k) \quad . \quad h_{Err}(k + \kappa)$$

3. Device according to Claim 1 or 2, characterized in that use is made of Durbin-Levinson recursion to solve the Yule-Walker equations for the coefficients $a_1 \ldots a_N$ of the linear predictor of prescribable order *(N)*, the equations being:

$$
\begin{bmatrix}
\rho(0) & \rho(1) & \ldots & \rho(N-1) \\
\rho(1) & \rho(0) & \ldots & \rho(N-2) \\
\ldots & \ldots & \ldots & \ldots \\
\rho(N-1) & \ldots & \ldots & \rho(0)
\end{bmatrix}
\begin{bmatrix}
a_1 \\
\ldots \\
a_N
\end{bmatrix}
=
\begin{bmatrix}
\rho(1) \\
\ldots \\
\rho(N)
\end{bmatrix}
$$

and, finally, the sequence {*1, -a₁, -a₂ ..., -aₙ*} resulting therefrom for the coefficients of the corrector pulse response.

4. Use of a linear predictor for the design of a transversal filter, in particular in the configuration in accordance with one of the preceding claims, in a system, the system comprising a linear, frequency-selective transmission block which, in particular, can be described in the form of a digital filter.

5. Use of a linear predictor in accordance with Claim 4 as a correcting device in a transmission system, in particular in a transmission system which comprises both electric and acoustic components.

6. Use of a linear predictor in accordance with Claim 3 or 1, characterized in that the filter of the transmission block is an FIR filter, that is to say as a Finite Impulse Response Filter, a filter with limited response to a pulse.

**Revendications**

1. Dispositif de correction d'un chemin de défaut dans un système de transmission, notamment un système de transmission électroacoustique mixte comme cela s'applique tout particulièrement à un système de réduction active du bruit,
   caractérisé en ce que
   le correcteur est formé d'un filtre transversal et sa conception repose sur la base de la prévision linéaire.

2. Dispositif selon la revendication 1,
   caractérisé en ce qu'
   à partir d'un nombre déterminé NE de coefficients de la réponse impulsionnelle du chemin identifié $h_{Err}(k)$ du chemin de défaut, on détermine l'autocorrélation correspondante $\rho(\kappa)$ selon l'équation de définition suivante :

$$\rho(\kappa) = \sum_{\kappa=0}^{NE-1-\kappa} = h_{Err}(k) \cdot h_{Err}(k + \kappa)$$

3. Dispositif selon la revendication 1 ou 2,
   caractérisé en ce qu'
   à l'aide de la récurrence Durbin-Levinson, on calcule les équations Yule-Walker pour les coefficients $a_1... a_N$ du prédicteur linéaire d'ordre (N), prédéterminés, les équations étant les suivantes :

$$\begin{bmatrix} \rho(0) & \rho(1) & ... & \rho(N-1) \\ \rho(1) & \rho(0) & ... & \rho(N-2) \\ ... & ... & ... & ... \\ \rho(N-1) & ... & ... & \rho(0) \end{bmatrix} \begin{bmatrix} a_1 \\ ... \\ a_N \end{bmatrix} = \begin{bmatrix} \rho(1) \\ .... \\ \rho(N) \end{bmatrix}$$

et pour les coefficients de la réponse impulsionnelle du correcteur, on en déduit finalement la suite {1, $-a_1$, $-a_2$, ..., $-a_N$}.

4. Application d'un prédicteur linéaire à la conception d'un filtre transversal, notamment par la réalisation selon l'une des revendications précédentes, avec un système composé d'un bloc de transmission linéaire sélectif en fréquence décrit notamment sous la forme d'un filtre numérique.

5. Application d'un prédicteur linéaire selon la revendication 4 comme dispositif de correction dans un système de transmission notamment dans un système de transmission formé à la fois de composants électriques et de composants acoustiques.

6. Application d'un prédicteur linéaire selon l'une des revendications 3 ou 4,
   caractérisée en ce que
   le filtre du bloc de transmission est un filtre FIR (filtre à réponse impulsionnelle finie), c'est-à-dire un filtre à réponse limitée pour une impulsion.

FIG.1